# FASCICULE DE BREVET EUROPEEN

(11) **EP 0 435 774 B1**
(45) Date de publication et mention de la délivrance du brevet: **01.02.1995**
(21) Numéro de dépôt: 90403786.8
(22) Date de dépôt: 27.12.1990
(51) Int. Cl.: H01L 21/00, B65G 65/00, B65G 49/07

(54) **Dispositif de chargement et de déchargement d'objets plats dans une cassette de rangement**
Vorrichtung zum Laden und Entladen einer Speicherkassette mit flachen Gegenständen
Device for loading and unloading a storage cassette with flat objects

(30) Priorité: 29.12.1989 FR 8917449
(43) Date de publication de la demande: 03.07.1991
(73) Titulaire: COMMISSARIAT A L'ENERGIE ATOMIQUE, 75015 Paris (FR)
(72) Inventeur: Cruz, Didier, F-38100 Grenoble (FR)
(74) Mandataire: Signore, Robert

(56) Documents cités:
- EP-A- 0 134 621
- EP-A- 0 253 162

## Description

Le domaine de l'invention est celui de la manipulation d'objets plats devant être rangés dans une cassette ou sortis de cette cassette. C'est en particulier le cas de la fabrication des circuits intégrés, où des plaques de silicium sont ainsi manipulées, rangées dans des cassettes, puis doivent en être extraites, dans le but d'effectuer sur elles d'autres opérations de fabrication.

Pour la fabrication des circuits intégrés sur des plaques de silicium, la gestion et la manipulation des plaques se fait à partir de cassettes de rangement dans lesquelles elles sont placées horizontalement. Chaque cassette possède une série de supports latéraux pouvant recevoir horizontalement une série de plaques de dimensions identiques. La manipulation des plaques impose l'utilisation d'un système permettant de prendre une plaque stockée dans une cassette et de remettre cette plaque dans une quelconque cassette et à n'importe quel étage.

Pour effectuer ces opérations de préhension et de remise en place d'une plaque dans une cassette, il est connu d'utiliser un mécanisme de préhension composé principalement d'un doigt préhenseur capable de prélever une seule plaque hors de la cassette et de l'y remettre. Compte tenu du très court espace en hauteur séparant deux plaques adjacentes, de l'ordre de 5 mm pour la norme "SEMI-ENGINEERING", les mouvements de ce doigt préhenseur doivent être très précis. En effet, tout système préhenseur doit pouvoir pénétrer sous la plaque à prélever sans rayer la plaque supérieure. Le positionnement en hauteur du doigt préhenseur est assuré par un dispositif mécanique très précis, onéreux, entraînant en translation verticale le doigt et son support. Le doigt préhenseur peut également rester fixe, le mouvement précis en translation verticale étant alors assuré par un autre dispositif mécanique entraînant la cassette. Dans ce dernier cas, c'est la précision du mécanisme de translation de la cassette qui est très coûteuse à obtenir.

Un premier but de l'invention est de fournir un dispositif de préhension et de lâchage d'une plaque dans une cassette qui soit extrêmement fin, c'es-à-dire qui puisse pénétrer entre les rayonnages de la cassette sans difficulté. Il faut, de plus, que sa manipulation soit aisée et le prix diminué, par rapport au dispositif préhenseur du type précédemment décrit.

Le document de brevet EP-A-0 253 162 décrit un dispositif et une méthode pour transférer des tranches de silicium d'une cassette, dans laquelle elles sont rangées, vers un poste de travail.

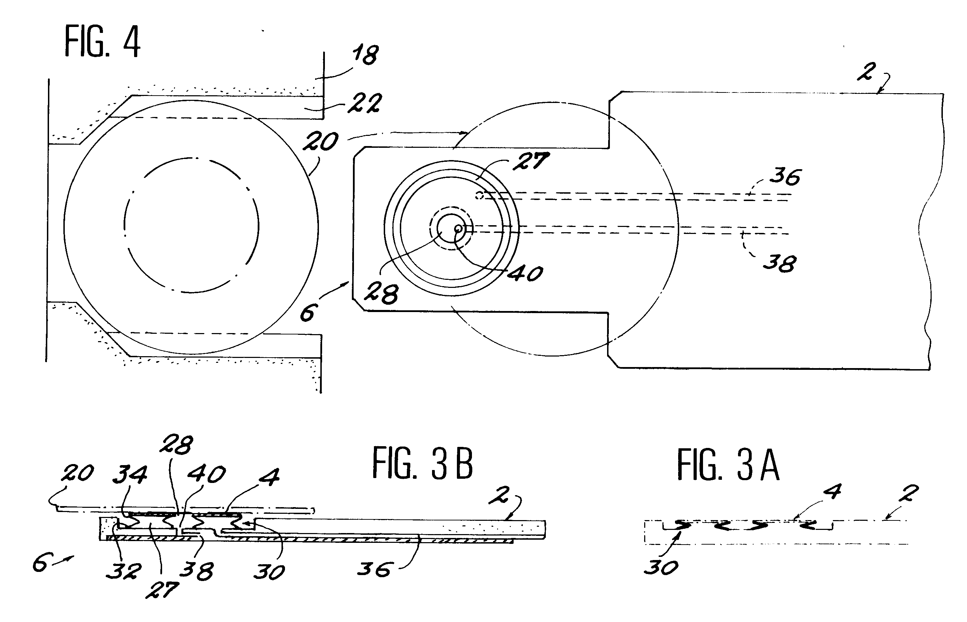

Ces moyens de transfert sont principalement constitués d'un bras (24) qui peut pivoter et être translaté horizontalement et verticalement. Sur ce bras (24), les moyens de préhension sont constitués, comme le montre la figure 3, d'une petite pièce d'extrémité (42) à laquelle est relié un petit tube (46) relié à une source de vide. Des orifices (44) débouchant sur la surface supérieure de cette pièce d'extrémité (42) permettent d'appliquer une dépression à l'objet placé sur cette petite pièce d'extrémité (42).

Le mouvement de montée nécessaire pour la saisie d'une tranche est assuré par une légère montée du bras.

A cet effet, l'objet principal de l'invention est un dispositif de chargement et de déchargement d'objets plats posés dans une cassette sur des supports latéraux de la cassette, le dispositif comportant au moins un ensemble de préhension et de repose dans la cassette d'un desdits objets plats. Selon l'invention, chaque ensemble de préhension et de repose comprend une plaque horizontale comportant, située à une des ses extrémités de largeur inférieure à la largeur interne de la cassette, une partie mobile dans le sens vertical au-dessus du plan de ladite extrémité et équipée de moyens assurant ce déplacement vertical, ladite partie mobile restant sensiblement parallèle à la plaque durant son mouvement vertical, l'extrémité devant être introduite dans la cassette et placée sous l'objet plat puis la partie mobile soulevée. L'objet plat est ainsi décollé des supports latéraux puis extrait de la cassette, la repose de l'objet plats sur les supports latéraux se faisant par redescente de ladite partie mobile après introduction de l'extrémité dans la cassette, la surface supérieure de l'extrémité étant dans un plan situé au-dessous de celui délimité par les surfaces supérieures des supports latéraux.

Une première réalisation des moyens de préhension et de lâchage est que ceux-ci sont complétés par au moins trois bilames, dont une première extrémité est fixée à la piste et une deuxième extrémité est fixée à la partie mobile de la piste. Une excitation des deux lames de chaque bilame provoque la déformation de celles-ci et la montée de la partie mobile. Une fois remis au repos, les bilames reprennent leur position initiale et la partie mobile est redescendue.

Le deuxième mode de réalisation préférentiel des moyens de préhension et de lâchage propose l'utilisation d'un soufflet déformable fixé à la fois à la piste par une première extrémité et à la partie mobile par une deuxième extrémité. Une pression ou une dépression à l'intérieur du soufflet provoque, par l'intermédiaire de celui-ci, la montée ou la descente de la partie mobile de la piste.

Dans ce cas de l'utilisation d'un soufflet déformable, celui-ci possède avantageusement une chambre principale externe reliée par une première conduite à des moyens de mise sous pression pour provoquer l'extension de celui-ci et le soulèvement de la partie mobile, la redescente étant provoquée par la mise à la pression ambiante de la chambre externe.

Un aspect de l'invention prévoit un orifice débouchant sur la surface supérieure de la partie mobile de la piste et relié à des moyens de mise en dépression par une deuxième conduite, pour créer une force de rétention de l'objet plat sur la partie mobile de la piste, lors de la manipulation de celui-ci.

Dans ce cas, le soufflet déformable se complète avantageusement d'une chambre interne débouchant sur la surface supérieure de la partie mobile par l'orifice et étant reliée à la deuxième conduite.

Les dispositifs préhenseurs de l'art antérieur ne possédant qu'un seul doigt préhenseur, ne permettent pas la manipulation simultanée de plusieurs plaques dans une même cassette.

Un deuxième but de l'invention et de remédier à cet inconvénient en proposant un dispositif de chargement et de déchargement pour charger et décharger une cassette de stockage ou de transport d'un nombre déterminé N d'objets plats, stockés parallèlement entre eux, posés sur des supports latéraux et séparés les uns des autres d'un écart déterminé E. Selon l'invention, les ensembles de préhension et de lâchage sont au même nombre déterminé N d'objets plats stockés et sont positionnés horizontalement, espacés chacun de la même hauteur H, de manière à ce que, en position dite descendue de ladite partie mobile de la piste, chaque piste vienne juste en-dessous de deux supports latéraux, pour permettre la saisie ou la pose d'un objet plat sur les supports latéraux placés juste au-dessus.

Dans ce cas, on peut prévoir des moyens de commande sélective pour actionner indépendamment les uns des autres les ensembles de préhension et de lâchage, pour saisir ou reposer n'importe quel objet plat placé dans une cassette ou sur une piste.

L'invention et ses caractéristiques techniques seront mieux comprises à la description qui suit, donnée à titre indicatif, mais non limitatif. Les dessins annexés représentent respectivement :
- figures 1A et 1B, des vues en perspective d'un premier mode de réalisation du dispositif selon l'invention ;
- figure 2, un schéma explicatif, en vue de dessus, du fonctionnement du dispositif décrit aux figures 1A et 1B ;
- figures 3A et 3B, deux vues latérales en coupe du deuxième mode de réalisation du dispositif selon l'invention ;
- figure 4, un schéma explicatif en vue de dessus, du fonctionnement du dispositif décrit aux figures 3A et 3B ;
- figure 5, une vue de face en coupe, d'une cassette dans laquelle sont entreposés des objets plats, entre lesquels est inséré le dispositif selon l'invention ;
- figure 6, une vue en coupe latérale montrant trois phases de préhension d'un objet plat dans une cassette ;
- figures 7A et 7B, deux schémas latéraux représentant le dispositif selon l'invention dans sa version multi-pistes, avant et après le chargement et le déchargement des objets plats dans une cassette ; et
- figure 8, une vue en perspective d'une réalisation possible d'une piste du dispositif selon l'invention dans sa version multi-pistes.

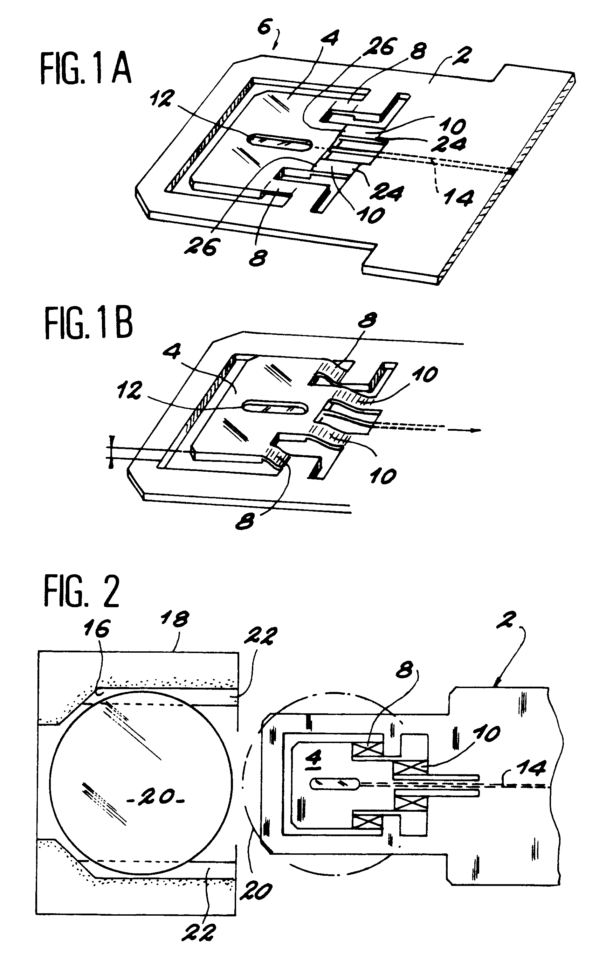

Le dispositif représenté sur la figure 1A est constitué principalement d'une piste 2. A l'extrémité 6 qui est représentée, se trouve un ensemble de préhension et de lâchage d'un objet plat. Pour donner un exemple d'objets plats, on peut citer les plaques de silicium sur lesquelles on fabrique des circuits intégrés dans le domaine de la micro-électronique. De telles plaques sont globalement rondes, avec un diamètre de l'ordre de 100 mm. Les cassettes dans lesquelles elles sont rangées ont, de préférence, un entraxe très faible, par exemple de 4,76 mm.

Selon l'invention, cet ensemble de préhension et de lâchage est constitué d'une partie mobile 4 de la piste 2. Celle-ci peut être soulevée et redescendue à volonté, selon que l'on veut saisir ou reposer un tel objet plat sur deux supports latéraux, par exemple ceux d'une cassette de rangement de plaques de silicium. En effet, pour saisir un objet plat placé dans une cassette de rangement 18, l'extrémité de préhension 6 de la piste 2 est placée sous l'objet plat 20, parallèlement à celui-ci. Comme le montre la partie droite de la figure 2, l'extrémité de préhension 6 de la piste 2 doit avoir une largeur inférieure à l'écart qui sépare les deux parois internes 16 de la cassette 18, pour pouvoir s'introduire dans cette cassette 18. La partie mobile 4 est alors soulevée, comme le montre la figure 1B, jusqu'à venir en contact avec la surface inférieure d'un objet plat en dessous duquel elle se trouve. En continuant son mouvement de montée, la partie mobile 4 a tendance à soulever l'objet plat 20 et à le décoller des deux supports latéraux, repérés 22 sur la figure 2, et sur lesquels l'objet plat était posé. Un mouvement de recul de l'ensemble de la piste, à l'extérieur de la cassette, permet d'extraire l'objet plat 20 de celle-ci.

La montée de la partie mobile 4 doit se faire de manière à ce que celle-ci reste sensiblement parallèle à l'objet plat qu'elle doit saisir, c'est-à-dire parallèle à la piste 2 introduite elle-même parallèlement en-dessous de l'objet plat.

Le premier mode de réalisation des moyens de préhension est complété par au moins trois bilames, représentés au nombre de quatre et repérés 8 et 10 sur les figures 1A et 1B. Par une première extrémité 24, les bilames 8 et 10 sont fixés à la piste 2. Par une deuxième extrémité 26, ils sont fixés à la partie mobile 4.

Le fonctionnement d'un tel ensemble est le suivant. La position de repos des bilames 8 et 10 est la position plate, c'est-à-dire qu'ils maintiennent la partie mobile 4 dans le même plan que celui de la piste 2. Lorsqu'ils sont excités, les bilames 8 et 10 se déforment de manière à ce que leurs deuxièmes extrémités 26, fixées à la partie mobile 4 effectuent un mouvement quasiment vertical vers le haut, soulevant ainsi la partie mobile 4. Pour que celle-ci reste relativement parallèle à la piste 2, les bilames doivent être au moins au nombre de trois, et de manière à ce que leurs deuxièmes extrémités 26, fixées à la piste 2, ne soient pas placées sur une même ligne, de manière à définir un plan. Il est également nécessaire que la déformation des bilames soit identique, de manière à ce que les deuxièmes extrémités 26 effectuent un mouvement d'une même hauteur. Un objet plat peut ainsi être soulevé par excitation des bilames 8 et 10.

Pour reposer l'objet plat sur ces supports latéraux, repérés 22 sur la figure 2, il suffit de cesser l'excitation des bilames 8 et 10, provoquant ainsi la redescente de la partie mobile 4. Celle-ci revient dans sa position de repos, mais sans l'objet plat 20 qui est reposé sur les supports latéraux 22 placés légèrement au-dessus du plan de la piste 2.

En référence à la figure 2, on prévoit de pouvoir maintenir l'objet plat 20 sur la partie mobile 4, pendant les différentes manipulations du dispositif. A cet effet, la partie mobile 4 possède un orifice 12 de succion débouchant sur la surface supérieure de cette partie mobile 4. Cet orifice 12 est relié, au moyen d'une première conduite 14, à des moyens de mise en dépression non représentés sur ces figures. Une des pressions aboutissant à l'orifice 12, crée un phénomène de succion sur un objet plat 20 placé sur la surface supérieure de la partie mobile 4. De même, la remise à la pression ambiante permet de pouvoir détacher facilement l'objet plat 20 de la partie mobile 4.

En référence aux figures 3A, 3B et 4, un deuxième mode de réalisation des moyens de préhension est constitué principalement d'un soufflet pneumatique 30 soulevant ou abaissant la partie mobile 4 de la piste 2. Celui-ci est placé à l'extrémité 6 de la piste 2, en-dessous de la partie mobile 4. L'extrémité inférieure 32 du soufflet 30 est fixée sur la piste 2. L'extrémité supérieure 34 du soufflet 30 est fixé à la partie mobile 4. L'intérieur du soufflet 30 est relié, par une première conduite 36 placée à l'intérieur de la piste 2, à des moyens de mise sous pression non représentés sur ces figures. La mise sous pression du soufflet conduit à une élévation de l'extrémité supérieure 34 de celui-ci et à un soulèvement d'un objet plat 20, lorsque le dispositif est placé juste en dessous d'un tel objet 20. La remise à la pression ambiante du soufflet 30 conduit à la redescente par gravité de l'extrémité supérieure 34 du soufflet 30, et par là-même, à la redescente de l'objet plat 20. Lorsque cette redescente s'effectue au-dessus de supports latéraux 22 d'une cassette 18, l'objet plat 20 se trouve posé sur ces supports latéraux 22.

Comme pour le premier mode de réalisation de cet ensemble de préhension, la partie mobile 4 est munie d'un orifice 40 débouchant sur la surface supérieure de la partie mobile 4 et est relié par une deuxième conduite 38 à des moyens de mise en dépression non représentés sur ces figures. La deuxième conduite 38 aboutit à l'orifice 40 par l'intermédiaire d'une chambre interne 28 du soufflet 30, placée au milieu de la chambre principale périphérique 27 du soufflet 30. Lorsqu'une dépression règne dans cette conduite 38 et cet orifice 40, un phénomène de succion apparaît à la surface supérieure de la partie mobile 4 et crée une force de rétention sur l'objet plat 20 placé sur cette surface supérieure de la pratie mobile 4. Ceci permet de maintenir l'objet plat 20 pendant les différentes manipulations du dispositif.

Comme le montre la figure 4, l'orifice 40 est placé de préférence au milieu de la partie mobile 4, de manière à pouvoir centrer la force de rétention sur l'objet plat 20.

Dans ce mode de réalisation utilisant un soufflet 30, il est nécessaire que ce dernier puisse s'écraser en position basse, pour se loger dans l'épaisseur de la piste, permettant ainsi l'insertion de la piste entre deux objets plats adjacents, placés à l'intérieur d'une cassette.

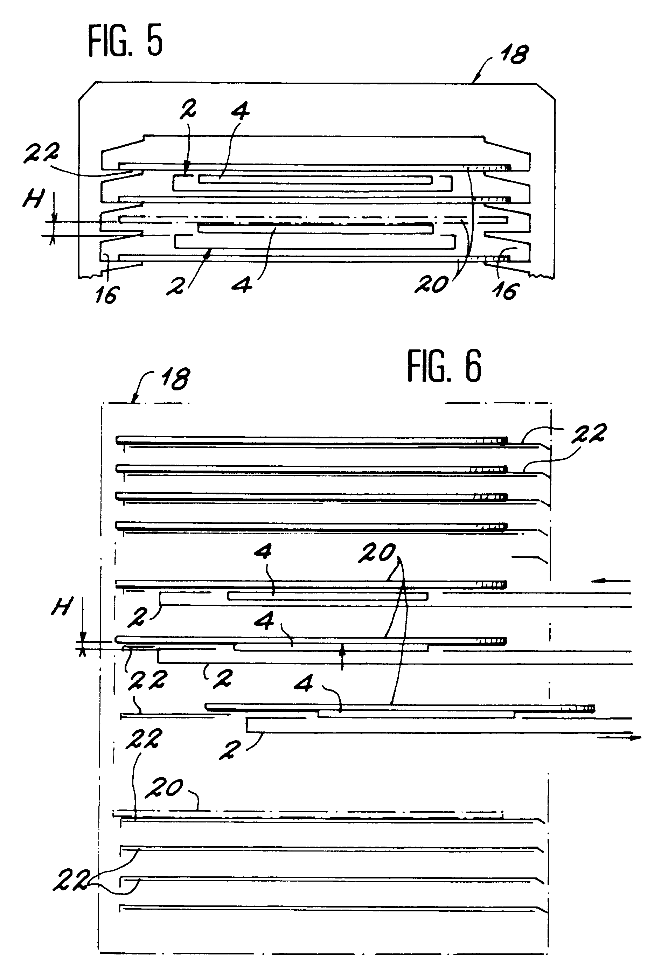

En se reportant aux figures 5 et 6, on peut constater l'efficacité et la fiabilité du dispositif selon l'invention. Celui-ci a été représenté avec des objets plats 20 et une cassette 18, dans laquelle ils sont placés, à une échelle d'un ordre de grandeur correspondant aux réalisations prévues. On constate que la largeur de la piste 2 est inférieure à l'écart des parois internes 16 de la cassette 18, de manière à pouvoir être insérée dans celle-ci. De préférence, cette largeur est inférieure à celle de l'espace délimité par les extrémités des supports latéraux 22, de manière à permettre une insertion du dispositif dans la cassette 18, même si la piste 2 n'est pas à la hauteur adéquate, c'est-à-dire en regard d'une paire de supports latéraux 22.

Toutefois, pour effectuer les opérations de chargement ou de déchargement d'un objet plat 20 dans la cassette 18, la piste 2 doit être introduite de manière à ce que sa surface supérieure soit dans un plan situé juste au-dessous de celui délimité par les surfaces supérieures des supports latéraux 22 sur lesquels se trouve l'objet à saisir ou sur lesquels on doit poser l'objet plat 20. Le déplacement vertical H de la partie mobile 4 doit être suffisant pour permettre un décollement de l'objet plat par rapport à ses supports latéraux 22, dans le cas d'un déchargement, et pour le reposer dans le cas d'un déchargement.

Sur la figure 6, on peut distinguer, symbolisée par la flèche orientée vers la gauche, l'insertion de la piste 2 sous un objet plat 20, la partie mobile 4 étant en position reposée.

Juste en-dessous est représentée l'opération de soulèvement de la partie mobile 4 par un mouvement vertical de celle-ci d'une valeur déterminée H. Cette dernière doit etre supérieure à la différence de hauteur initiale entre la surface supérieure de la partie mobile 4 et les surfaces supérieures des supports latéraux 22.

En-dessous, on a montré un déplacement latéral, vers la droite, de la piste 2 supportant l'objet plat 20, pour extraire celui-ci de la cassette.

L'échauffement des bilames de type thermique peut être obtenu par exemple par résistance chauffante ou par effet Joule. La déformation est instantanée. Le fonctionnement est identique pour le bilame piézoélectrique qui réagit instantanément sous l'action d'une tension électrique.

Le dispositif selon l'invention permet donc de ranger et de sortir des objets plats devant être stockés dans une cassette sans que la cassette ou le dispositif n'effectue de mouvements verticaux au moment de la saisie ou de la repose de l'objet plat. Ceci supprime la présence d'un mécanisme spécial de montée ou de descente, ce dernier devant être très précis pour que l'objet ne touche pas les objets adjacents, lors de sa manipulation.

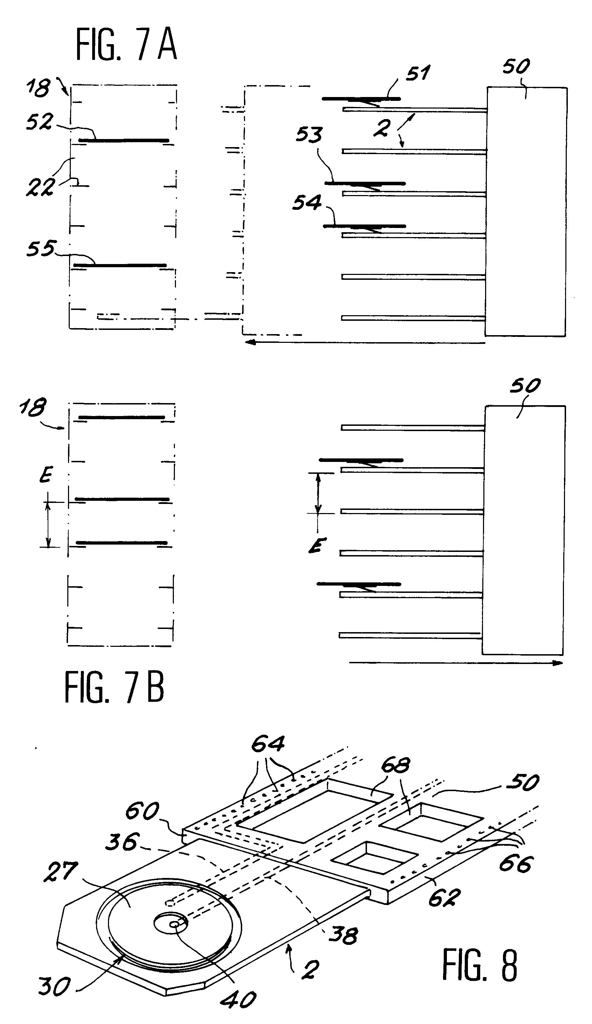

L'invention prévoit la construction d'un dispositif de chargement et de déchargement utilisant plusieurs ensembles de préhension et de lâchage. On dispose alors d'un outil multi-pistes très performant pour charger et décharger des cassettes de plaques de silicium en grande quantité, pendant une durée relativement réduite par rapport aux durées nécessaires lorsque ces opérations sont effectuées avec des outils préhenseurs unitaires. La conception d'un tel outil est décrite à l'aide des figures 7A, 7B et 8.

La figure 7A montre un dispositif comportant un bloc principal 50 et des pistes 2 portant trois objets plats 51, 53, 54, placés respectivement sur les première, troisième et quatrième pistes 2. Le bloc principal 50 comporte des moyens de mise sous pression et de mise en dépression, dans le cas de l'utilisation de soufflets. Il peut comporter les moyens de mise en dépression et des générateurs de tension pour actionner des bilames, lorsque ceux-ci sont utilisés pour soulever les objets plats. Dans ces deux cas, le bloc principal 50 comprend des moyens de commande sélective, de manière à pouvoir commander indépendamment les différents ensembles de préhension et de lâchage placés au bout des pistes 2. Il est en effet très avantageux de pouvoir saisir ou reposer n'importe quel objet plat placé soit dans la cassette 18, soit sur une piste 2.

La figure 7A montre le dispositif selon l'invention en mouvement vers une cassette 18. Il est porteur d'objets 51, 53 et 54 arrangés sur leurs pistes respectives 2. Les pistes 2 s'insèrent par leur extrémité 6 à l'intérieur de la cassette 18. Les ensembles de préhension et de lâchage sont actionnés ensuite pour reposer les objets plats 51, 53 et 54 et pour soulever les objets plats 52 et 55, stockés au préalable dans la cassette 18. Comme le montre la figure 7B, la dernière opération consiste à retirer le dispositif en dehors de la cassette 18 par un mouvement horizontal en sens inverse de celui effectué pour insérer le dispositif dans la cassette 18.

L'utilisation d'un tel dispositif nécessite la présence d'un nombre déterminé N de pistes correspondant au même nombre N de rayonnages dans la cassette 18. Le position en hauteur de chaque piste du dispositif doit également être fait en fonction du positionnement en hauteur de la cassette 18. Il est en effet nécessaire que chaque piste puisse s'insérer juste en-dessous de deux supports latéraux 22 pour pouvoir saisir ou poser un objet plat sur ces supports latéraux placés juste au-dessus. Les pistes 2 sont séparées les unes des autres d'un écart E déterminé. Celle-ci est également la hauteur qui sépare deux supports latéraux 22 dans la cassette 18.

La figure 8 montre un ensemble de préhension et de lâchage pneumatique utilisé dans un dispositif de chargement et de déchargement multi-pistes. il comporte tous les éléments décrits par les figures 3A, 3B et 4. Par contre, on peut remarquer que la piste 2 est soutenue par une tranche du bloc principal 50. Les parois latérales 60 et 62 de celui-ci contiennent des canalisations verticales 64 et 66. Dans un premier de ces côtés 60, les canalisations verticales 64 aboutissent chacune à une première canalisation 36 alimentant la chambre principale périphérique 27 du soufflet 30. Chaque canalisation 66 du deuxième côté 62 alimente une deuxième conduite 38 débouchant, par l'intermédiaire de la chambre interne 28, à l'orifice de succion 40. Chaque canalisation 64 ou 66 est reliée à une électrovanne commandée par les moyens de commande sélective. On peut également envisager l'utilisation d'un micro-processeur pour commander le dispositif selon l'invention.

On constate qu'un tel outil peut permettre d'effectuer des chargements et des déchargements "à la carte". L'opérateur peut ainsi commander ou programmer le chargement d'un nombre déterminé de rayonnages d'une cassette tout en pouvant décharger certains autres rayonnages.

La figure 8 montre la possibilité de pratiquer des évidements 68 dans la tranche du bloc principal 50, et ceci dans le but d'alléger le dispositif.

Les modes de réalisation décrits précédemment ne constituent que des exemples de mise en oeuvre du concept du dispositif selon l'invention. Ce dernier étant l'utilisation d'une partie mobile de pistes pouvant se soulever pour saisir un objet plat et se rabaisser pour le reposer sur son rayonnage.

## Revendications

1. Dispositif de chargement et de déchargement d'objets plats (20) posés dans une cassette (18) sur des supports latéraux (22) de la cassette (18), le dispositif comportant au moins un ensemble de préhension et de repose dans la cassette (18) d'un desdits objets plats (20), caractérisé en ce que chaque ensemble de préhension et de repose comprend une plaque horizontale (2) comportant, située à une de ses extrémités (6) de largeur inférieure à la largeur interne de la cassette (18), une partie (4) mobile dans le sens vertical au-dessus du plan de ladite extrémité (6) et équipée de moyens (8, 10, 30) assurant ce déplacement vertical, ladite partie mobile (4) restant sensiblement parallèle à la plaque (2) durant son mouvement vertical, l'extrémité (6) devant être introduite dans la cassette et placée sous l'objet plat (20), puis la partie mobile (4) soulevée, l'objet plat étant ainsi décollé des supports latéraux (22), puis extrait de la cassette (18), la repose de l'objet plat (20) sur les supports latéraux (22) se faisant par redescente de ladite partie mobile (4) après introduction de l'extrémité (6) dans la cassette (18), la surface supérieure de l'extrémité (6) étant dans un plan situé au-dessous de celui délimité par les surfaces supérieures des supports latéraux (22).

2. Dispositif selon la revendication 1, caractérisé en ce que les moyens de préhension sont équipés d'au moins trois bilames (8, 10) dont une première extrémité (24) est fixée à la plaque (2) et dont une deuxième extrémité (26) est fixée à ladite partie mobile (4) de la plaque (2).

3. Dispositif selon la revendication 1, caractérisé en ce que les moyens de préhension sont équipés d'au moins un soufflet (30) déformable, fixé à la fois à la plaque (2) par une première extrémité inférieure (32) et à la partie mobile (4) par une deuxième extrémité supérieure (34).

4. Dispositif selon la revendication 3, caractérisé en ce que le soufflet (30) possède une chambre principale périphérique (27), reliée par une conduite (36) à un moyen de mise sous pression assurant l'extension dudit soufflet et le soulèvement de la partie mobile (4), la redescente de cette partie mobile (4) étant provoquée par la mise à la pression ambiante de la chambre principale périphérique (27).

5. Dispositif selon l'une quelconque des revendications précédentes, caractérisé en ce que la partie mobile (4) possède au moins un orifice (12, 40) débouchant sur la surface supérieure de la partie mobile (4) et étant relié par une conduite (14,38) à des moyens de mise en dépression créant une force de rétention de l'objet plat (20) sur la partie mobile (4) de la plaque (2), lors de la manipulation de l'objet plat (20).

6. Dispositif selon les revendications 4 et 5, caractérisé en ce que le soufflet (30) possède une chambre interne (28), placée au milieu de la chambre périphérique (27), débouchant sur la surface supérieure de la partie mobile (4) par l'orifice (40) et étant reliée à la deuxième conduite (38).

7. Dispositif selon l'une quelconque des revendications précédentes, destiné à charger et décharger une cassette (18) d'objets plats (51, 52, 53, 54 et 55) stockés parallèlement entre eux, posés sur des supports latéraux (22) qui sont d'un nombre déterminé (N) et séparés les uns des autres d'un écart déterminé (E), caractérisé en ce qu'il possède un même nombre déterminé (N) d'ensembles de préhension et de repose positionnés horizontalement, espacés chacun dudit écart (E), la surface supérieure de chaque plaque (2) étant, en position descendue de la partie mobile (4) de la plaque (2), dans un plan qui est situé au-dessous de celui délimité par les surfaces supérieures des supports latéraux (22), un objet plat (51, 52, 53, 54 et 55) pouvant ainsi être saisi ou posé sur les supports latéraux (22) placés juste au-dessus.

8. Dispositif selon la revendication 7, caractérisé en ce qu'il comprend des moyens de commande sélective permettant d'actionner indépendamment les uns des autres les ensembles de préhension et de repose, n' importe quel objet plat (51, 52, 53, 54 et 55) placé dans une cassette (18) ou sur une plaque (2) pouvant ainsi être saisi ou reposé.

## Patentansprüche

1. Vorrichtung zu Laden und Entladen von flachen Gegenständen (20) in einer Kassette (18), auf seitlichen Trägern (22) der Kasette (18) abgelegt, wobei die Vorrichtung wenigstens eine Einheit zum Greifen und Ablegen in der Kassette (18) von einem der besagten flachen Gegenstände (20) umfaßt,
**dadurch gekennzeichnet**, daß jede Greif- und Ablegeeinheit eine horizontale Platte (2) umfaßt, die an einem ihrer Enden (6), mit einer kleineren Breite als die innere Breite der Kassette (18), einen Teil (4) besitzt, beweglich in Vertikalrichtung über der Ebene des besagten Endes (6) und ausgestattet mit Einrichtungen (8, 10, 30), die diese Vertikalbewegung gewährleisten, daß der genannte bewegliche Teil während seiner Vertikalbewegung im wesentlichen parallel bleibt zu der Platte (2) und das Ende (6) in die Kassette eingeführt und unter dem flachen Gegenstand (20) angeordnet werden muß, dann der bewegliche Teil (4) angehoben und der flache Gegenstand somit von den seitlichen Trägern (22) abgehoben und dann aus der Kassette (18) herausgezogen wird, daß das Ablegen des flachen Gegenstands (20) auf den seitlichen Trägern (22) durch Wiederabsenken des beweglichen Teils (4) nach Einführung des Endes (6) in die Kassette (18) erfolgt, wobei die obere Fläche des Endes (6) sich in einer Ebene unter der befindet, die begrenzt wird durch die oberen Flächen der seitlichen Träger (22).

2. Vorrichtung nach Anspruch 1, dadurch gekennzeichnet, daß die Greifeinrichtungen ausgestattet sind mit wenistens drei Bimetallelementen (8, 10), von denen ein erstes Ende (24) an der Platte (2) befestigt ist und von denen ein zweites Ende (26) an dem genannten beweglichen Teil (4) der Platte (2) befestigt ist.

3. Vorrichtung nach Anspruch 1, dadurch gekennzeichnet, daß die Greifeinrichtungen ausgestattet sind mit wenigstens einem verformbaren Balg (30), zugleich befestigt an der Platte (2) durch ein erstes, unteres Ende (32) und an dem beweglichen Teil (4) durch ein zweites, oberes Ende (34).

4. Vorrichtung nach Anspruch 3, dadurch gekennzeichnet, daß der Balg (30) eine periphere Hauptkammer (27) besitzt, verbunden über eine Leitung (36) mit einer Druckerzeugungseinrichtung, die die Ausdehnung des Balgs und das Anheben des beweglichen Teils (4) gewährleistet, wobei das Wiederabsenken dieses beweglichen Teils (4) dadurch bewirkt wird, daß man in der peripheren Hauptkammer (27) Umgebungsdruck herstellt.

5. Vorrichtung nach einem der vorhergehenden Ansprüche, dadurch gekennzeichnet, daß der bewegliche Teil (4) wenigstens eine Öffnung (12, 40) besitzt, die an der oberen Fläche des beweglichen Teils (4) mündet und über eine Leitung (14, 38) verbunden ist mit Unterdruckeinrichtungen, die eine Haltekraft des flachen Gegenstands (20) am beweglichen Teil (4) der Platte (2) erzeugen bei der Handhabung des flachen Gegenstands (20).

6. Vorrichtung nach den Ansprüchen 4 und 5, dadurch gekennzeichnet, daß der Balg (30) eine Innenkammer (28) besitzt, angeordnet in der Mitte der peripheren Kammer (27), an der oberen Fläche des beweglichen Teils (4) mündend durch eine Öffnung (40) und mit der zweiten Leitung (38) verbunden.

7. Vorrichtung nach einem der vorhergehenden Ansprüche, bestimmt zum Laden und Entladen einer Kassette (18) mit flachen Gegenständen (51, 52, 53, 54 und 55), parallel zueinander gelagert, abgelegt auf seitlichen Trägern (22), mit einer bestimmten Anzahl (N) und getrennt voneinander durch einen bestimmten Abstand E, dadurch gekennzeichnet, daß sie dieselbe bestimmte Anzahl (N) Greif- und Ablegeeinheiten umfaßt, die horizontal positioniert sind und besagten Abstand (E) voneinander aufweisen, wobei die obere Fläche jeder Platte (2) in abgesenkter Position des beweglichen Teils (4) der Platte (2) sich in einer Ebene befindet, die tiefer liegt als die, die begrenzt wird durch die oberer Flächen der seitlichen Träger (22) und ein flacher Gegenstand (51, 52, 53, 54 und 55) somit ergriffen oder abgelegt werden kann auf den seitlichen Trägern (22), die sich direkt darüber befinden.

8. Vorrichtung nach Anspruch 7, dadurch gekennzeichnet, daß sie selektive Steuerungseinrichtungen umfaßt, die ermöglichen, unabhängig voneinander die einen oder anderen der Greif- und Ablegeeinheiten zu betätigen, um somit einen beliebigen, in einer Kassette (18) oder auf einer Platte (2) angeordneten flachen Gegenstand (51, 52, 53, 54 und 55) zu ergreifen oder abzulegen.

## Claims

1. Apparatus for loading and unloading flat articles (20) placed in a cassette (18) on lateral supports (22) of the cassette (18), said apparatus having at least one assembly for gripping and releasing a flat article (20) with respect to the cassette (18), characterized in that each gripping and release assembly comprises a horizontal plate (2) having, facing one of its ends (6) of width smaller than the internal width of the cassette (18), a part (4) which is mobile in the vertical direction above the plane of said end (6) and equipped with means (8, 10, 30) ensuring said vertical displacement, said mobile part (4) remaining substantially parallel to the plate (2) during its vertical movement, the (6) end having to be introduced into the cassette and placed below the flat object (20) and then the mobile part (4) is raised, the flat object thus being disengaged from the lateral supports (22) and extracted from the cassette (18), the release of flat objects (20) onto the lateral supports (22) taking place by the lowering again of said mobile part (4) following the introduction of the end (6) into the cassette (18), the upper surface of the end (6) being in a plane below that defined by the upper surfaces of the lateral supports (22).

2. Apparatus according to claim 1, characterized in that the gripping means are equipped with at least three biplates (8, 10), whereof a first end (24) is fixed to the plate (2) and whereof a second end (26) is fixed to said mobile part (4) of the plate (2).

3. Apparatus according to claim 1, characterized in that the gripping means are equipped with at least one deformable bellows (30), fixed both to the plate (2) by a first lower end (32) and to the mobile part (4) by a second upper end (34).

4. Apparatus according to claim 3, characterized in that the bellows (30) has a main peripheral chamber (27) connected by a pipe (36) to a pressurizing means ensuring the extension of said bellows and the raising of the mobile part (4), the relowering of said mobile part (4) being brought about by the placing under ambient pressure of the main peripheral chamber (27).

5. Apparatus according to any one of the preceding claims, characterized in that the mobile part (4) has at least one orifice (12, 40) issuing onto the upper surface of the mobile part (4) and being connected by a pipe (14, 38) to vacuum-producing means creating a retention force of the flat object (20) on the mobile part (4) of the plate (2) during the handling of the flat object (20).

6. Apparatus according to claims 4 and 5, characterized in that the bellows (30) has an internal chamber (28) placed in the centre of the peripheral chamber (27) issuing onto the upper surface of the mobile part (4) by the orifice (40) and being connected to the second pipe (38).

7. Apparatus according to any one of the preceding claims for loading and unloading a cassette (18) with flat objects (51, 52, 53, 54 and 55) stored parallel to one another and placed on lateral supports (22) present in a given number (N) and separated from one another by a predetermined clearance (E), characterized in that it has a same predetermined number (N) of horizontally positioned gripping and release means, each spaced by said clearance (E), the upper surface of each plate (2) being, in the lowered position of the mobile part (4) of the plate (2), in a plane located below that defined by the upper surfaces of the lateral supports (22), whereby a flat object (51, 52, 53, 54 and 55) can thus be grasped or placed on the lateral supports (22) placed just above it.

8. Apparatus according to claim 7, characterized in that it comprises selective control means making it possible to independently actuate the gripping and release assemblies, so that any random flat object (51, 52, 53, 54 and 55) placed in a cassette (18) or on a plate (2) can be seized or released.
